# EUROPÄISCHE PATENTANMELDUNG

(11) **EP 4 576 967 A1**
(43) Veröffentlichungstag der Anmeldung: **25.06.2025**
(21) Anmeldenummer: 24217161.9
(22) Anmeldetag: 03.12.2024
(51) Int. Cl.: H05K 7/20, F24F 1/24, H01L 23/467

(54) **ANORDNUNG ZUR KÜHLUNG EINES WÄRMEPUMPENUMRICHTERS**

(30) Priorität: 22.12.2023 DE 102023136567
(71) Anmelder: Stiebel Eltron GmbH & Co. KG, 37603 Holzminden (DE)
(72) Erfinder: STRATE, Joscha, 32756 Detmold (DE); LÖWENS, Thomas, 37627 Stadtoldendorf (DE); FITZ, Jannik, 37603 Holzminden (DE)

(57) **Zusammenfassung**

Die vorliegende Erfindung betrifft eine Anordnung zur Kühlung (10) eines Wärmepumpenumrichters mit Luft, wobei die Anordnung zur Kühlung (10) zumindest einen mit elektronischen Bauteilen (12) des Wärmepumpenumrichters wärmeleitend verbundenen metallischen, mit Kühlrippen (32) ausgebildeten Kühlkörper (30), einen Luftführungskühlkanal (20), in dem der Kühlkörper (30) angeordnet ist, eine Lufteintrittsöffnung (22) in den Luftführungskühlkanal (20) und eine Luftaustrittsöffnung (24) aus dem Luftführungskühlkanal (20) umfasst. Die Lufteintrittsöffnung (22) ist so angeordnet, dass Außenluft einströmen kann und die Luftaustrittsöffnung (24) weist eine Verbindung zu einem Lüfterinnenraum (40) auf, wobei der Lüfterinnenraum (40) auf der Saugseite (42s) eines Lüfters (42) angeordnet ist.

## Beschreibung

Die Erfindung betrifft eine Anordnung zur Kühlung - im Weiteren auch Kühlungsanordnung - eines Wärmepumpenumrichters mit Luft.

Leistungsgeregelte Wärmepumpen arbeiten drehzahlvariabel. Um die Drehzahl des Kompressors und/oder bei Luftwärmepumpen des Ventilators und damit die Leistung zu steuern werden die Kältemittelkompressoren mittels Umrichter, auch als Inverter bekannt, mit elektrischer Energie versorgt. Hierzu werden die Frequenz und/oder Amplitude der Spannung im Umrichter an die jeweiligen Anforderungen angepasst. Dazu kommen elektronische Bauteile zum Einsatz, wobei Wärme entsteht, die nur zum Teil über natürliche Konvektion abgeführt werden kann. Um die zulässige Maximaltemperatur der elektronischen Bauteile nicht zu überschreiten und dementsprechend Schäden an den Bauteilen zu vermeiden, müssen diese gegebenenfalls auch aktiv gekühlt werden. Dabei ist darauf zu achten, dass die Elektronik nicht auf eine Temperatur unterhalb der Taupunkttemperatur gekühlt wird, da sonst Kondensat auf der Elektronik anfallen und dieses zu einem Kurzschluss führen kann.

Die Umrichter von Wärmepumpen können mit Wasser, Luft und mittels Wärmerohren (heatpipe) gekühlt werden.

Die vorliegende Erfindung betrifft eine Kühlung der elektronischen Bauteile (Leistungselektronik) des Umrichters einer Luftwärmepumpe mit Luft.

Luftgekühlte Wärmepumpenumrichter nutzen zumeist den durch den Lüfter einer Luftwärmepumpe bereitgestellten Unterdruck.

Bei bekannten Lösungen befindet sich der Kühlkörper direkt im Lüfterraum und demzufolge in Strömungsrichtung hinter dem Verdampfer. Die Luft strömt sowohl von der Seite des Verdampfers als auch durch Schlitze von vorne über den Kühlkörper. Aufgrund des über den Verdampfer geführten Luftstroms kann die Temperatur des Kühlkörpers im Heizbetrieb unter die Kondensationstemperatur der Luft fallen, so dass sich kondensierte Luftfeuchtigkeit auf den elektronischen Bauteilen niederschlagen kann.

Die Aufgabe der vorliegenden Erfindung besteht darin, eine verbesserte Anordnung zur Kühlung eines Wärmepumpenumrichters mit Luft bereitzustellen. Insbesondere soll der Kühlkörper zur Reinigung leicht zugänglich sein. Weiterhin soll die erfindungsgemäße Kühlungsanordnung eine kompakte Bauweise und einen geringen Luftwiderstand aufweisen. Weiterhin soll verhindert werden, dass es an den elektronischen Bauteilen zu einer Taupunktunterschreitung und damit zu einer schädigenden Kondensation von Luftfeuchtigkeit an den elektronischen Bauteilen kommt.

Erfindungsgemäß wird die Aufgabe durch eine Anordnung zur Kühlung eines Wärmepumpenumrichters mittels Luft mit den nachfolgend angegebenen Merkmalen gelöst.

Die Anordnung zur Kühlung umfasst zumindest einen mit elektronischen Bauteilen des Wärmepumpenumrichters wärmeleitend verbundenen metallischen, mit Kühlrippen ausgebildeten Kühlkörper, einen Luftführungskühlkanal, in dem der Kühlkörper angeordnet ist, eine Lufteintrittsöffnung in den Luftführungskühlkanal und eine Luftaustrittsöffnung aus dem Luftführungskühlkanal.

Erfindungsgemäß ist vorgesehen, dass gemäß einer ersten Option die Luftaustrittsöffnung eine Verbindung zu einem Lüfterinnenraum aufweist, wobei der Lüfterinnenraum auf der Saugseite eines Lüfters angeordnet ist. Der Lüfter ist dabei vorzugsweise ein Lüfter, der den Luftstrom durch den Verdampfer einer Luftwärmepumpe realisiert. Dadurch weist der Lüfterinnenraum einen Unterdruck gegenüber dem Umgebungsdruck auf.

Dementsprechend wird von dem Lüfter Luft durch die Luftaustrittsöffnung und damit durch den Luftführungskühlkanal angesogen. Dementsprechend strömt die angesogene Außenluft durch die Lufteintrittsöffnung in den Luftführungskühlkanal ein, durchströmt den Luftführungskühlkanal mit dem darin angeordneten Kühlkörper, so dass dieser mit Außenluft gekühlt wird. Nachfolgend strömt dann die Luft über den Lüfterinnenraum zum Lüfter, wobei der Lüfter den Unterdruck im Lüfterinnenraum realisiert.

Unter Außenluft wird die Luft verstanden, die nicht über Verdampfer geführt und dementsprechend nicht gekühlt wurde.

Die Lufteintrittsöffnung ist vorzugsweise mit einem Gitter versehen, um zu vermeiden, dass Insekten, Blätter oder ähnliches in den Luftführungskühlkanal gelangen können.

Gemäß einer zweiten Option ist erfindungsgemäß vorgesehen, dass der Luftführungskühlkanal im Bereich des Kühlkörpers von drei Seiten von dem Kühlkörper und von einer Seite von einer lösbar mit dem Kühlkörper verbundenen Abdeckplatte umschlossen ist. Dementsprechend ist der Kühlkörper durch die Kühlrippen mit einem kammartigen Profil ausgebildet.

Durch die lösbare (mittelbare oder unmittelbare) Verbindung der Abdeckplatte mit dem Kühlkörper kann diese zu Inspektions- und Reinigungszwecken entfernt werden. Dementsprechend werden durch die Entfernung der Abdeckplatte die Kühlrippen des Kühlkörpers zugänglich.

Die Abdeckplatte kann sich auch über den Bereich des Kühlkörpers hinaus erstrecken.

Durch die auf drei Seiten geschlossene Ausbildung des Kühlkörpers und die Abdeckplatte wird vermieden, dass der Kühlluftstrom über die elektronischen Bauteile geführt wird. Dementsprechend werden dort Verschmutzungen und die schädigende Kondensation der Luftfeuchtigkeit der Kühlluft an der Oberfläche der elektronischen Bauteile vermieden. Dadurch, dass der Kühlkörper mit der Abdeckplatte den Luftführungskühlkanal bildet, kann die Kühlung des Umrichters mit wenigen Bauteilen kompakt ausgeführt werden.

Bevorzugt bildet die Abdeckplatte zugleich die Seitenwand der Lüfter- und/oder Verdampfereinheit der Wärmepumpe. Damit wird eine kompakte Bauweise realisiert. Zugleich verringert sich der Material- und Montageaufwand.

Alternativ deckt die Abdeckplatte den Luftführungskanal bei abgenommener Seitenwand der Lüftereinheit und/oder Verdampfereinheit der Wärmepumpe ab. Damit ist ein Testbetrieb der Wärmepumpe auch bei abgenommener bzw. geöffneter Seitenwand möglich.

Besonders bevorzugt ist die Abdeckplatte in diesem Fall abnehmbar, so dass ein Funktionstest zum Abschluss der Fertigung mit der Abdeckplatte ohne Seitenwand durchführbar ist, da der Luftführungskanal auch bei abgenommener Seitenplatte dicht ist. An den Funktionstest anschließend kann die separate Abdeckplatte entnommen werden und die Dichtfunktion durch die Seitenwand erfüllt werden oder, alternativ, kann die Seitenwand über die noch eingesetzte Abdeckplatte montiert werden, so dass der Arbeitsschritt des Entfernens der Abdeckplatte entfällt. Vorzugsweise ist zwischen dem Kühlkörper und der Abdeckplatte eine elastische Dichtung angeordnet. Somit können durch die Dichtung Fertigungstoleranzen von Kühlkörper und Abdeckplatte ausgeglichen werden. Die Dichtung sorgt zudem dafür, dass in den Luftführungskühlkanal keine unerwünschte Nebenluft eindringen kann.

Bevorzugt erstreckt sich die Dichtung über die gesamte Abdeckplatte und besteht aus einem Schaumstoff. Damit wirkt die Dichtung schalldämmend, so dass die wahrnehmbaren Lüftergeräusche reduziert werden.

Vorzugsweise ist zwischen dem Luftführungskühlkanal und der Lufteintrittsöffnung ein Lufteintrittsabschnitt und/oder zwischen dem Luftführungskühlkanal und der Luftaustrittsöffnung ein Luftaustrittsabschnitt angeordnet. Der Lufteintrittsabschnitt und/oder der Luftaustrittsabschnitt führen den Luftstrom zum von Kühlkörper gebildeten Luftführungskühlkanal, wobei dabei der Luftstrom so umgelenkt werden kann, dass entsprechend der Position und Ausrichtung der Kühlungsanordnung vorteilhaft Außenluft angesaugt, über den Kühlkörper gelenkt und in den Lüfterinnenraum geführt werden kann. Dazu sind der Lufteintrittsabschnitt und/oder der Luftaustrittsabschnitt so ausgebildet, dass der Luftstrom um etwa 90 Grad umgelenkt wird. In anderen Ausführungen sind auch Umlenkungen im Bereich von 30° bis 120° vorteilhaft.

Bevorzugt ist im Lufteintrittsabschnitt eine Luftleiteinrichtung angeordnet, die einen größeren Teil des Luftstroms in den Bereich des Kühlkörpers lenkt, der sich an die elektronischen Bauteile anschließt und/oder der Luftaustrittsabschnitt in dem Bereich des Kühlkörpers angeordnet, der sich an die elektronischen Bauteile anschließt. Durch die bevorzugten Ausgestaltungen wird ein größerer Teil des Luftstroms in den Bereich des Kühlkörpers gelenkt, der sich an die elektronischen Bauteile anschließt, damit eine höhere Temperatur aufweist und dementsprechend bevorzugt zur Kühlung durchströmt werden soll.

Erfindungsgemäß wird die Aufgabe weiterhin durch einen Kühlkörper zur Kühlung von elektronischen Bauteilen gelöst, wobei der Kühlkörper durch eine in den Kühlkörper integrierte rückseitige Kühlkanalbegrenzung und zwei integrierte seitliche Kühlkanalbegrenzungen von drei Seiten begrenzt und auf der offenen Seite mit einer Abdeckplatte verschließbar ist. Dementsprechend ist der Kühlkörper von drei Seiten geschlossen und ausgebildet sowie vorzugsweise aus einem Stück, wie vorzugsweise stranggepresst, gefertigt.

Durch die vierseitige Begrenzung wird ein Kühlkörper geschaffen, der einen geschlossenen Kühlkanal ausbildet, wobei der Kühlkanal durch die Abdeckplatte zu Inspektions- und Reinigungszwecken geöffnet werden kann.

Weitere vorteilhafte Ausgestaltungen und Vorteile werden nachfolgend unter Hinzuziehung der beigefügten Figuren beschrieben:
- Fig. 1: zeigt eine Perspektivansicht einer Anordnung zur Kühlung eines Wärmepumpenumrichters,
- Fig. 2a: zeigt schematisch einen Wärmepumpenverdampfer mit Lüfter und Kühlungsanordnung in einer Seitenansicht,
- Fig. 2b: zeigt eine Perspektivansicht eines Ausschnitts einer Wärmepumpe,
- Fig. 3: zeigt einen Kühlkörper in einer Seitenansicht,
- Fig. 4: zeigt einen Kühlkörper gemäß Fig. 3 in einer Schnittansicht,
- Fig. 5: zeigt einen modifizierten Kühlkörper in einer Schnittansicht,
- Fig. 6: zeigt einen weiteren modifizierten Kühlkörper in einer Schnittansicht und
- Fig. 7: zeigt eine Modifikation mit separater Abdeckplatte.

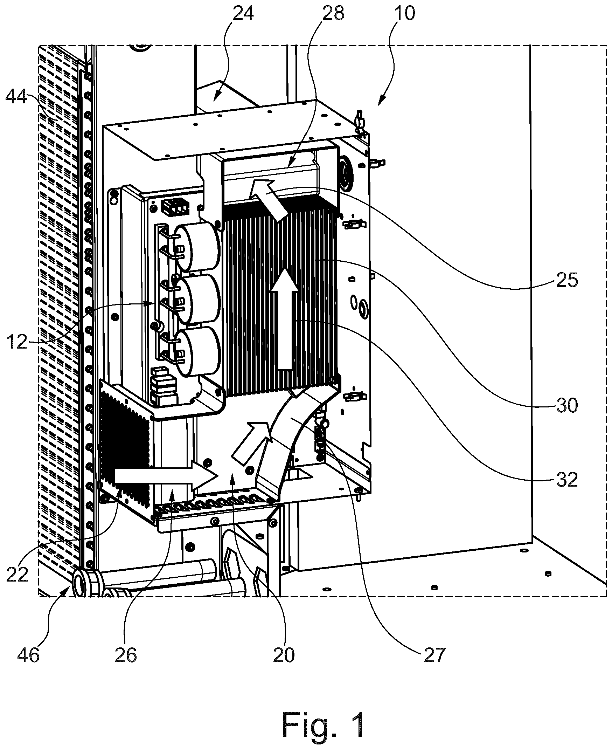

Die Fig. 1 zeigt in einer Perspektivansicht eine Anordnung 10 zur Kühlung eines Wärmepumpenumrichters, wobei der Wärmepumpenumrichter elektronische Bauteile 12 umfasst, die im Besonderen gekühlt werden. Die elektronischen Bauteile 12 sind wärmeleitend mit einem Kühlkörper 30 verbunden, wobei dieser mit Kühlrippen 32 kammartig ausgebildet ist.

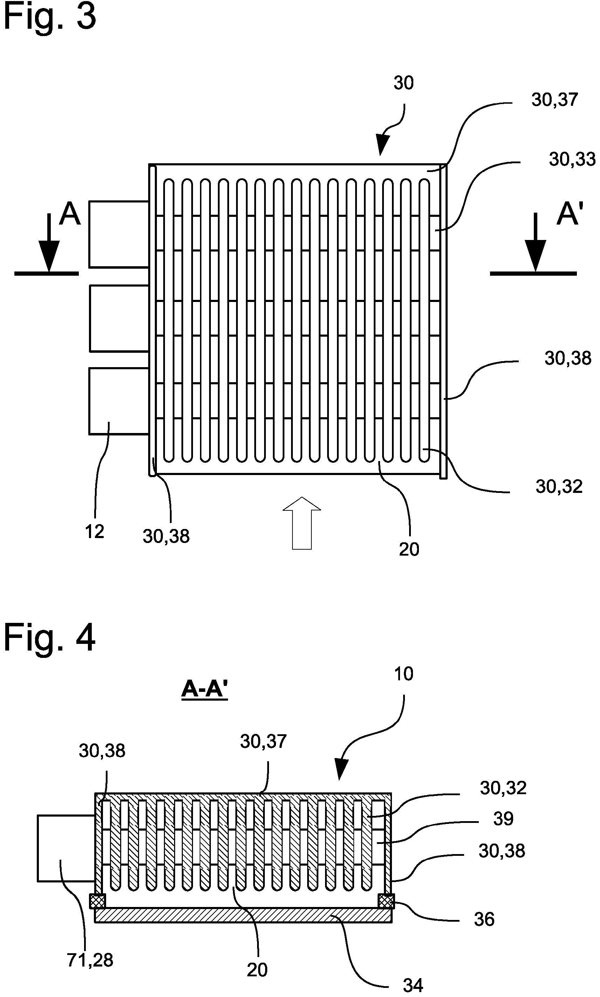

Die konkreten Ausführungen des Kühlkörpers 30 sind in den Figuren 3 bis 6 dargestellt und in der zugehörigen Beschreibung beschrieben.

Die Kühlung erfolgt mit (nicht über den Verdampfer geleiteter) Außenluft, die durch eine Lufteintrittsöffnung 22 der Kühlungsanordnung 10 angesogen wird und über einen Lufteintrittsabschnitt 26 in die Kühlungsanordnung 10 gelangt. Im Lufteintrittsabschnitt 26 wird der Luftstrom um 90° nach oben abgelenkt und tritt in den Kühlkörper 30 ein, wobei die Luft zwischen den Kühlrippen 32 entlang strömt und damit die Wärme von den Kühlrippen 32 aufnimmt.

Bevorzugt ist der Lufteintrittsabschnitt 26 so ausgebildet, dass eine darin angeordnete Luftleiteinrichtung 27 den Luftstrom bevorzugt in den Bereich der höheren Temperaturen des Kühlkörpers 30, also in den Bereich des Kühlkörpers 30 lenkt, der mit den elektronischen Bauteilen 12, verbunden ist. Die Luftleiteinrichtung 27 ist vorzugsweise als ein in der Weise geformtes Kundstoffteil ausgebildet, das den Großteil des Luftstroms in den bauteilnahen Bereich des Kühlkörpers 30 lenkt. Der Raum innerhalb des geschlossen ausgebildeten Kühlkörpers 30 mit den Kühlrippen 32 wird als Luftführungskühlkanal 20 bezeichnet.

Nachfolgend tritt die Luft in den Luftaustrittsabschnitt 28 ein, wird wiederum um 90° umgelenkt und tritt durch die Luftaustrittsöffnung 24 aus der Kühlungsanordnung 10 aus. An die Luftaustrittsöffnung 24 schließt sich ein Luftaustrittskanal 29 an, der die Luft in einen Lüfterinnenraum 40 führt. In dem Lüfterinnenraum 40 ist auch der Verdampfer angeordnet.

Der die Luft umlenkende Lufteintrittsabschnitt 26 beziehungsweise Luftaustrittsabschnitt 28 ist nicht erforderlich, wenn die Luftaustrittsöffnung 24 und die Lufteintrittsöffnung 22 sich unmittelbar an den Kühlkörper 30 anschließen.

Zu sehen ist, dass der Luftstrom ebenfalls nicht über die Platine oder die Elektronikbauteile 12 selbst geführt wird. Damit wird ein Kondensatabfall an der Platine oder den Elektronikbauteilen 12 wirksam verhindert.

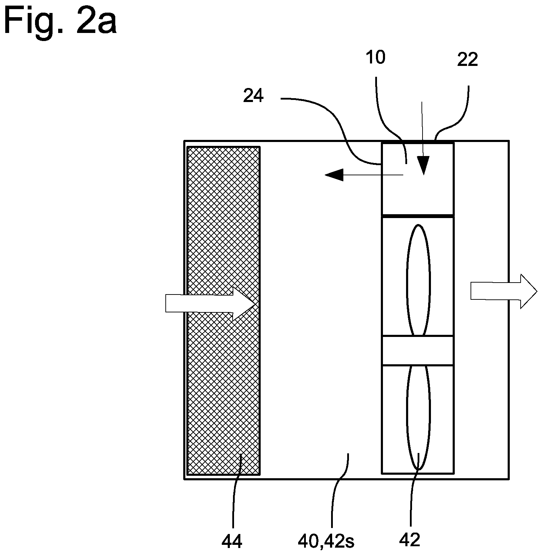

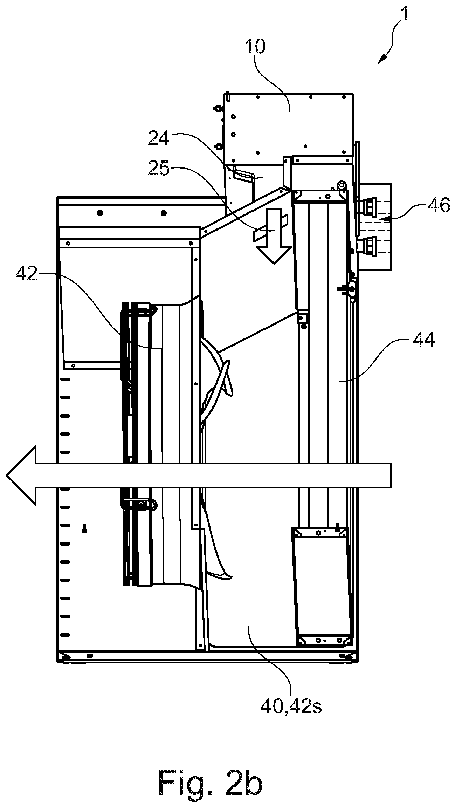

Ebenfalls zu sehen sind Hydraulikanschlüsse 46 zum Anschließen der Wärmepumpe an Hydraulikleitungen und ein Verdampfer bzw. eine Verdampfereinheit 44, die von der Kühlungsanordnung 10 räumlich getrennt ist. Der Luftstrom 25 führt, wie in Fig. 2a und 2b genauer gezeigt, aus der Kühlungsanordnung 10 in einen Lüfterinnenraum 40.

Der Luftstrom zur Kühlung wird von einem Lüfter 42 erzeugt, wie in Fig. 2a schematisch in einer Seitenansicht gezeigt. Dementsprechend ist die Kühlungsanordnung 10 in Bezug auf die Darstellung in Fig. 1 von oben gezeigt.

Der Lüfter 42 saugt über den auf dessen Saugseite 42s angeordneten Verdampfer 44 der Luftwärmepumpe Luft von außen an, wobei aus dem Druckverlust über den Verdampfer 44 ein Unterdruck im Lüfterinnenraum 40 resultiert.

Durch die Verbindung des mit Unterdruck beaufschlagten Lüfterinnenraums 40 mit der Luftaustrittsöffnung 24 (an der oberen Seite der Kühlungsanordnung 10 gemäß Fig. 1) wird neben der durch den Verdampfer geführten Luft weiterhin Außenluft über die Lufteintrittsöffnung 22 (in Fig. 2a nicht gezeigt) der Kühlungsanordnung 10 angesaugt und damit der Luftstrom zum Betrieb der Kühlungsanordnung 10 realisiert.

Die Anordnung der Kühlungsanordnung 10 relativ zu dem Lüfter 42 ist natürlich nur beispielhaft gezeigt und kann auch anders ausgeführt sein, solange die Luftaustrittsöffnung 24 der Kühlungsanordnung 10 in dem Bereich zwischen Verdampfer 44 und Saugseite 42s des Lüfters 42 angeordnet ist.

Fig. 2b zeigt eine weitere Ansicht eines Abschnitts einer Wärmepumpe 1, in der sowohl der Lüfterinnenraum 40 als auch die Anordnung zur Kühlung 10 gezeigt sind. Zudem ist die Lufteintrittsöffnung 22 und die Luftaustrittsöffnung 24 in den Lüfterinnenraum samt Luftstrom 25 gezeigt.

Die Fig. 3 zeigt einen erfindungsgemäßen Kühlkörper 30 in Anlehnung an Fig. 1 ohne Abdeckplatte (nicht dargestellt) in einer Seitenansicht von der Seite her, auf der die Abdeckplatte angeordnet ist. Der Kühlkörper 30 ist mit zwei seitlichen Kühlkanalbegrenzungen 38 und einer rückseitigen Kühlkanalbegrenzung 37 ausgebildet, die damit zugleich als Kühlrippen 32 fungieren. Dementsprechend wird der durch den Kühlkörper 30 führende Luftführungskühlkanal 20 von dr<ei Seiten begrenzt. Die Kühlrippen 32 sind hier wärmeleitend durch Kühlrippenverbindungselemente 39 mit den zu kühlenden elektronischen Bauteilen 12 verbunden.

In Fig. 4 ist ein Schnitt A-A' durch den in Fig. 3 dargestellten Kühlkörper 30 gezeigt. Hier wird deutlich, dass der durch den Kühlkörper 30 führende Luftführungskühlkanal 20 von drei Seiten durch die seitlichen Kühlkanalbegrenzungen 38 und die rückseitige Kühlkanalbegrenzung 37 begrenzt ist. Die verbleibende offene Seite wird mit einer lösbar angeordneten Abdeckplatte 34 verschlossen. Da die Abdeckplatte 34 demontierbar ist, kann der Kühlkörper 30 inspiziert und gegebenenfalls gereinigt werden. Zwischen dem Kühlkörper 30 und der Abdeckplatte 34 ist eine elastische Dichtung 36 zum Ausgleich von Fertigungstoleranzen und zur Abdichtung gegenüber dem Eindringen von Nebenluft angeordnet,

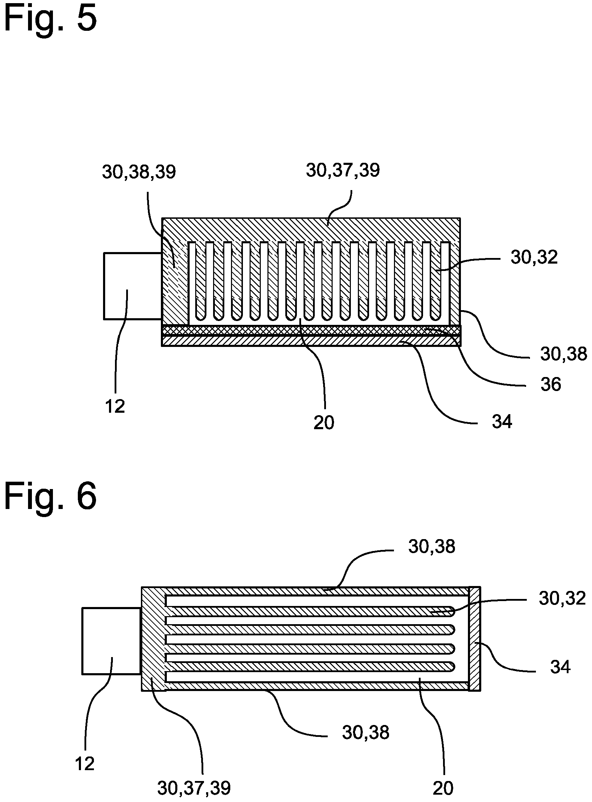

In Fig. 5 ist eine Schnittdarstellung in derselben Ebene wie in Fig. 4 durch einen modifiziert ausgebildeten Kühlkörper 30 gezeigt. Der Unterschied besteht darin, dass hier die separaten Kühlrippenverbindungselemente 39 entfallen und dafür eine seitliche Kühlkanalbegrenzung 38 und die rückseitige Kühlkanalbegrenzung 37 mit einem stärkeren Querschnitt ausgebildet sind, so dass hier die Wärmeleitung innerhalb des Kühlkörpers 30 verbessert ist. Zudem ist hier zwischen Abdeckplatte 34 und Kühlkörper 30 eine Dichtung 36 aus Schaumstoff vorgesehen, die Fertigungstoleranzen ausgleicht und damit insbesondere das ungewollte Eindringen von Luft verhindert. Die Dichtung 36 erstreckt sich hier über die gesamte Abdeckplatte 34.

Die Fig. 6 zeigt eine Schnittdarstellung in derselben Ebene wie in Fig. 4 durch einen alternativ ausgebildeten Kühlkörper 30. Hier sind die elektronischen Bauteile 12 auf der schmaler ausgebildeten rückseitigen Kühlkanalbegrenzung 37 angeordnet, die zugleich als wärmeleitendes Kühlrippenverbindungselement 39 ausgebildet ist. Durch diese Anordnung wird die Wärmeabfuhr von den elektronischen Bauteilen 12 verbessert.

Zugleich wird deutlich, dass der Kühlkörper 30 der erfindungsgemäßen Kühlungsanordnung 10 in unterschiedlichen geometrischen Ausbildungen realisiert werden kann.

Ebenso kann die Ausrichtung des Kühlkörpers 30 und damit die der Kühlungsanordnung 10 abweichend von den Ausführungsbeispielen beispielsweise auch horizontal orientiert sein.

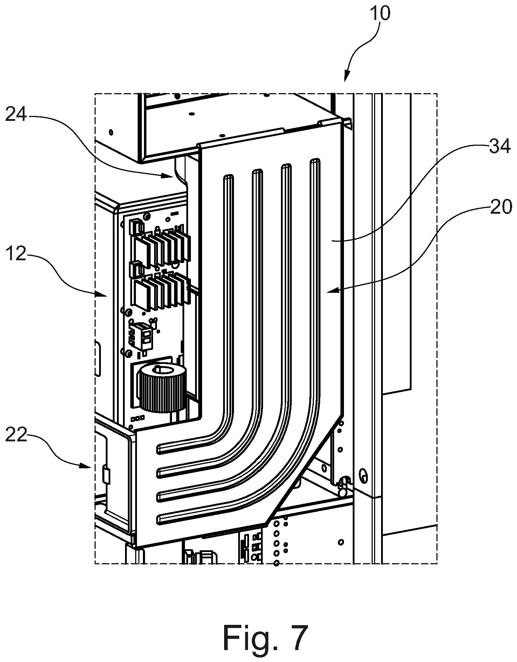

In Fig. 7 ist eine weitere Ansicht auf den Luftführungskanal der Kühlungsanordnung 10 gezeigt, wobei hier eine von der Seitenwand separate Abdeckplatte 34 zum Abschließen des Luftführungskanals vorgesehen ist. Eine solche Abdeckplatte 34 kann insbesondere im Testbetrieb beim Abschluss der Fertigung von Vorteil sein, da die Funktionsfähigkeit der Anlage auch ohne montierte Seitenwand getestet werden kann. Die Abdeckplatte 34 kann nach Abschluss der Funktionstests an Ort und Stelle verbleiben oder vor der Montage der Seitenwand wieder entnommen werden.

### Bezugszeichenliste

- 1: Wärmepumpe
- 10: Anordnung zur Kühlung, Kühlungsanordnung
- 12: elektronische Bauteile
- 20: Luftführungskühlkanal
- 22: Lufteintrittsöffnung
- 24: Luftaustrittsöffnung
- 25: Luftströmung
- 26: Lufteintrittsabschnitt
- 27: Luftleiteinrichtung
- 28: Luftaustrittsabschnitt
- 29: Luftaustrittskanal
- 30: Kühlkörper
- 32: Kühlrippen
- 34: Abdeckplatte
- 36: Dichtung, Schaumstoffdichtung
- 37: rückseitige Kühlkanalbegrenzung
- 38: seitliche Kühlkanalbegrenzung
- 39: Kühlrippenverbindungselement
- 40: Lüfterinnenraum
- 42: Lüfter, Lüftereinheit
- 42s: Saugseite des Lüfters
- 44: Verdampfer, Verdampfereinheit
- 46: Hydraulikanschlüsse

## Patentansprüche

1. Anordnung zur Kühlung (10) eines Wärmepumpenumrichters mit Luft,
- wobei die Anordnung zur Kühlung (10) zumindest einen mit elektronischen Bauteilen (12) des Wärmepumpenumrichters wärmeleitend verbundenen metallischen, mit Kühlrippen (32) ausgebildeten Kühlkörper (30), einen Luftführungskühlkanal (20), in dem der Kühlkörper (30) angeordnet ist, eine Lufteintrittsöffnung (22) in den Luftführungskühlkanal (20) und eine Luftaustrittsöffnung (24) aus dem Luftführungskühlkanal (20) umfasst,
**dadurch gekennzeichnet, dass**
- die Lufteintrittsöffnung (22) so angeordnet ist, dass Außenluft einströmen kann und
- die Luftaustrittsöffnung (24) eine Verbindung zu einem Lüfterinnenraum (40) aufweist, wobei der Lüfterinnenraum (40) auf der Saugseite (42s) eines Lüfters (42) angeordnet ist.

2. Anordnung zur Kühlung (10) eines Wärmepumpenumrichters mit Luft,
- wobei die Anordnung zur Kühlung (10) zumindest einen mit elektronischen Bauteilen (12) des Wärmepumpenumrichters wärmeleitend verbundenen metallischen, mit Kühlrippen (32) ausgebildeten Kühlkörper (30), einen Luftführungskühlkanal (20), in dem der Kühlkörper (30) angeordnet ist, eine Lufteintrittsöffnung (22) in den Luftführungskühlkanal (20) und eine Luftaustrittsöffnung (24) aus dem Luftführungskühlkanal (20) umfasst,
**dadurch gekennzeichnet, dass**
der Luftführungskühlkanal (20) im Bereich des mit Kühlrippen (32) ausgebildeten kammartigen Kühlkörpers (30) von drei Seiten von dem Kühlkörper (30) und von einer Seite von einer lösbar mit dem Kühlkörper (30) (mittelbar oder unmittelbar) verbundenen Abdeckplatte (34) umschlossen ist.

3. Anordnung zur Kühlung (10) nach Anspruch 1, wobei der Luftführungskühlkanal (20) im Bereich des mit Kühlrippen (32) ausgebildeten kammartigen Kühlkörpers (30) von drei Seiten von dem Kühlkörper (30) und von einer Seite von einer lösbar mit dem Kühlkörper (30) (mittelbar oder unmittelbar) verbundenen Abdeckplatte (34) umschlossen ist.

4. Anordnung zur Kühlung (10) eines Wärmepumpenumrichters nach Anspruch 2 oder 3, wobei die Abdeckplatte (34) zugleich die Seitenwand der Lüftereinheit (42) und/oder Verdampfereinheit (44) der Wärmepumpe bildet.

5. Anordnung zur Kühlung (10) eines Wärmepumpenumrichters nach Anspruch 2 oder 3, wobei die Abdeckplatte (34) den Luftführungskanal (20) bei abgenommener Seitenwand der Lüftereinheit (42) und/oder Verdampfereinheit (44) der Wärmepumpe abdeckt.

6. Anordnung zur Kühlung (10) eines Wärmepumpenumrichters nach einem der vorstehenden Ansprüche, wobei zwischen dem Kühlkörper (30) und der Abdeckplatte (34) eine elastische Dichtung (36) angeordnet ist.

7. Anordnung zur Kühlung (10) eines Wärmepumpenumrichters nach Anspruch 6, wobei die Dichtung (36) sich über die gesamte Abdeckplatte (34) erstreckt und/oder aus einem Schaumstoff besteht.

8. Anordnung zur Kühlung (10) eines Wärmepumpenumrichters nach einem der vorstehenden Ansprüche, wobei
zwischen dem Luftführungskühlkanal (20) und der Lufteintrittsöffnung (22) ein Lufteintrittsabschnitt (26) und/oder zwischen dem Luftführungskühlkanal (20) und der Luftaustrittsöffnung (24) ein Luftaustrittsabschnitt (28) angeordnet ist und der Lufteintrittsabschnitt (26) und/oder der Luftaustrittsabschnitt (28) so ausgebildet ist, dass der Luftstrom um 30° bis 120°, vorzugsweise um 60° bis 100° und insbesondere um 90° umgelenkt wird.

9. Anordnung zur Kühlung (10) eines Wärmepumpenumrichters nach Anspruch 8, wobei
der Lufteintrittsabschnitt (26) eine Luftleiteinrichtung (27) umfasst, die einen größeren Teil des Luftstroms in einen Bereich des Kühlkörpers (30) lenkt, der sich an die elektronischen Bauteile (12) anschließt und/oder dass der Luftaustrittsabschnitt (28) in dem Bereich des Kühlkörpers (30) angeordnet ist, der sich an die elektronischen Bauteile (12) anschließt.

10. Kühlkörper (30) für die Kühlung von mit dem Kühlkörper (30) verbundenen elektronischen Bauteilen (12), wobei der Kühlkörper (30) durch eine in den Kühlkörper (30) integrierte rückseitige Kühlkanalbegrenzung (37) sowie zwei in den Kühlkörper (30) integrierte seitliche Kühlkanalbegrenzungen (38) von drei Seiten begrenzt ist und auf der offenen Seite mit einer Abdeckplatte (34) verschließbar ist.
